## Europäisches Patentamt

## European Patent Office

## Office européen des brevets

(11) Publication number: **0 174 469**
**B1**

(12) **EUROPEAN PATENT SPECIFICATION**

(45) Date of publication of patent specification: **02.01.91**

(51) Int. Cl.⁵: **G 11 C 5/00,** G 11 C 16/00, G 11 C 17/00

(21) Application number: **85109072.0**

(22) Date of filing: **19.07.85**

(54) Charge-up circuit.

(30) Priority: **13.08.84 JP 169060/84**

(43) Date of publication of application:
**19.03.86 Bulletin 86/12**

(45) Publication of the grant of the patent:
**02.01.91 Bulletin 91/01**

(84) Designated Contracting States:
**DE FR GB**

(56) References cited:
**EP-A-0 137 245**
**WO-A-84/01659**
**US-A-4 404 475**

(73) Proprietor: **FUJITSU LIMITED**
**1015, Kamikodanaka Nakahara-ku**
**Kawasaki-shi Kanagawa 211 (JP)**

(72) Inventor: **Arakawa, Hideki**
**13-17, Umegaoka Midori-ku**
**Yokohama-shi Kanagawa, 227 (JP)**

(74) Representative: **Schmidt-Evers, Jürgen, Dipl.-Ing. et al**
**Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10**
**D-8000 München 22 (DE)**

## Description

The present invention relates to a charge-up circuit fabricated in an IC (integrated circuit) chip or die. A charge-up circuit having a charge-up characteristic of an extremely large time constant is often required in IC devices. A typical example of its application is for generating an E—W (erasing and writing) voltage which has a characteristic that it gradually rises from a low level to a high level taking a long time. The E—W voltage is used for changing the data in an EEPROM (electrically erasable programmable read only memory) or a NOVRAM (non-volatile random access memory) each fabricated in the memory chip and has a high voltage level of, for example, 20—30 volts in contrast to the ordinary power supply voltage of 5 volts for IC devices.

The data in the EEPROM or NOVRAM can be electrically changed by the E—W voltage when a changing command is applied to the memory chip from a computer system which includes the memory chip. The NOVRAM combines the function of a static RAM (SRAM) and an EEPROM so that it operates as the SRAM when the computer system is operating, however the data in the SRAM are transferred into the EEPROM and stored in it when the power source of the computer system is turned off. The EEPROM and NOVRAM come to be frequently used in the computer system because the data can be easily changed comparing with other EPROM (erasable programmable read only memory). For example, a UV-EPROM (ultravoilet rays EPROM) has been used much in the computer system, however it has been inconvenient because a memory chip including the UV-EPROM or a board installing the memory chips must be taken out from the computer system to irradiate ultraviolet rays for erasing the stored data whenever the data are required to be changed. On the contrary, in the EEPROM or NOVRAM, the data can be easily changed electrically by a program previously provided for exemple, so the task such as taking out the memory chip or the board from the computer system are not required any more.

However, the EEPROM or the NOVRAM (NOVRAM is a kind of EEPROM as mentioned above, so only EEPROM will be discussed hereinafter) has a demerit that the E—W voltage has to be applied to the EEPROM in a long time as long as 100 microsec (µS)~10 milli-sec (m S) for changing the data. Such time-interval is an extraordinarily large amount, because recently the speed of nanosecond becomes common in the field of the computer, so it becomes a problem to provide the long time-interval in the computer system. Means for determining the time-interval is usually provided in the memory chip, because if not, the processing speed of the computer system slows down. For example, if the CPU (central processing unit) in the computer system is occupied for a long time to change the data of EEPROM, the overall processing speed of the computer system will be much decreased. However, another problem occurs in the memory chip that a large space is required and the fabricating cost increases to provide the long time-interval.

In the case of EEPROM, the E—W voltage is required to have a waveform rising gradually from a low level to a high level taking a long time-interval such as 100µ S~500µ S and remaining at the high level for an extremely long time-interval such as 5m S±10m S for erasing the data stored in the EEPROM and writing new data into the EEPROM. When the waveform as mentioned above is applied to the EEPROM, electrons or holes are injected into the EEPROM for erasing or writing the data under the principle of tunnel effect: if a high level of the E—W voltage was rapidly applied to the EEPROM, the tunnel effect layer fabricated in the EEPROM would be broken. The waveform having a graded rising edge is provided by a unit called as a high voltage waveform generator and the long time-interval is controlled by a unit called as a timer circuit. Both units are fabricated in the IC chip and have a charge-up circuit respectively. The charge-up circuit substantially consists of a CR (capacitor and resistor) circuit having a long time constant, and in the timer circuit, the long time-interval is determined by the time period from initiation of charge-up operation up until the end point at which the voltage level of the charge-up node reaches a predetermined value. In order to prolong the time-interval, the high voltage source is used for the charge-up operation.

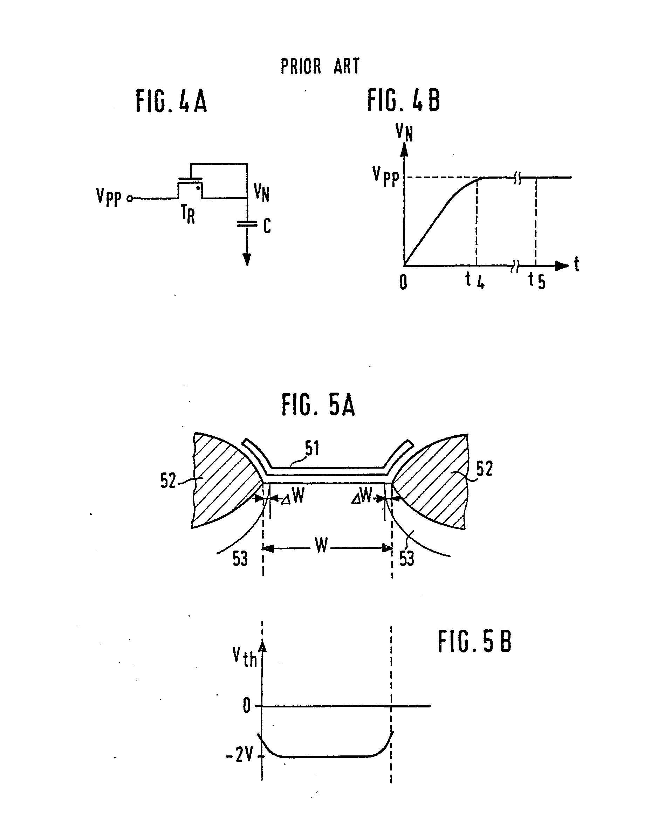

Fig. 4(a) shows a charge-up circuit of the prior art. In the figure, a symbol $T_R$ is a D (depletion type MIST (metal insulator semiconductor transistor) which is used as a resistor of the CR circuit being connected between a high source voltage $V_{pp}$ and a capacitor C. A charging current flows from high source voltage $V_{pp}$ to capacitor C through transistor $T_R$, and a charge-up voltage $V_N$ charged on capacitor C gradually increases as shown in Fig. 4(b). In Fig. 4(b), charge-up voltage $V_N$ is raised up to a level being just below high source voltage $V_{pp}$ from a starting level during a time-interval $0—t_4$. In the case of erasing the data in the EEPROM, the time-interval $0—t_4$ is 100µ S~500µ S, and in the case of writing new data into the EEPROM, the time-interval $0—t_5$ is 5m S~10m S. The variation of respective time-intervals depends on the characteristic of EEPROM.

The high voltage waveform generator and the timer circuit are triggered by the E—W control signals applied externally from the computer system. A high voltage like 25V (volts) is necessary for generating the long time-interval in the CR circuit, and the high voltage is usually supplied from a high voltage source fabricated in the IC chip. The high voltage source comprises a clock oscillator and a charge-pump circuit; the clock oscillator generates a clock signal consisting of a series of clock pulses, and the charge-pump circuit produces the high voltage using the clock signal.

In the prior art charge-up circuit shown in Fig.

4(a), there are problems of capacitor C and transistor $T_R$.

The problem of capacitor C is as follows. The capacitance of capacitor C becomes large as much as more than 10 picofarad (p F) to obtain a long time constant like $100\mu$ S~10m S, and the dielectric substance of capacitor C, which is an insulating layer (silicon dioxide layer), must have a large thickness to endure the high voltage. Therefore, very large size of capacitor C as much as

$$100\times100 \ (\mu \text{ m})^2\sim400\times400 \ (\mu \text{ m})^2$$

($\mu$ m=micro meter) is required.

The problem of transistor $T_R$ is as follows. When charge-up voltage $V_N$ increases, the back bias of transistor $T_R$ also increases so as to cut off transistor $T_R$ before change-up voltage $V_N$ reaches to high source voltage $V_{pp}$ if transistor $T_R$ is an ordinary D type having an ordinary threshold voltage $V_{th}$. This means that charge-up voltage $V_N$ cannot increase sufficiently high, in other words, the required long time-interval cannot be obtained by the ordinary D type MIST. So, transistor $T_R$ is modified so as to be a special D type MIST (modified MIST) having a sufficiently low threshold voltage $V_{th}$ (a low threshold voltage $V_{th}$ means a threshold voltage whose absolute value is large but in the negative side). However, the modified MIST costs very much because a special mask for an ion implantation is required to fabricate the modified MIST in the memory chip for isolating it from other adjacent oridinary MISTs; the ion implantation is for lowering the threshold voltage $V_{th}$. Furthermore, there is another problem about the size of the modified MIST, more particularly a problem about a channel width (W) and a channel length (L) of the modified MIST. Generally, a MIST has following character: a current-voltage characteristic (a characteristic between a source-drain current and gate-source voltage) is such that the ratio of the source-drain current to the gate-source voltage is in proportion to a ratio W/L; and the size of the MIST mostly depends on L. Therefore, channel width W must be narrow to fabricate a small size MIST, however, it is hard to make channel width W as narrow as less than $4\mu$ m in the case of the modified MIST. Generally, in the fabricating process of a MIST, a boron ion ($B^+$) for a channel cut is implanted around an FOX (field oxide layer used as a source and a drain of the MIST) to avoid occurring parasitic transistors. However the boron ion tends to diffuse out during the thermal diffusion process in the fabrication. Fig. 5(a) illustrates a cut view of a D type MIST, in the figure, reference numeral 51 is a gate electrode, 52 is an FOX, 53 is a boron-doped region in which the boron ion is implanted, reference numeral W shows a channel width, and $\Delta$W shows a width of the overlapped part of the channel width and the boron region. Generally, threshold voltage $V_{th}$ at the overlapped part becomes higher than that at the other part being not overlapped. Therefore, if the channel width W is too narrow comparing with the overlapped part

$\Delta$W, the part ($2\Delta$W) providing a high threshold voltage $V_{th}$ becomes superior to the part (W—$2\Delta$W) providing a low threshold voltage $V_{th}$ in the channel width, in other words, it is hard to fabricate a MIST so as to have a low threshold voltage $V_{th}$ unless the channel width W is wide, for example, the curve of threshold voltage $V_{th}$ in Fig. 5(b) shows the local threshold voltage $V_{th}$ of channel width W and overlapped part $\Delta$W along the channel width. Therefore, in the case of the modified MIST, channel width W cannot be made narrow, so channel length L becomes large, then the size of the modified MIST cannot be made small. For example, channel length L becomes between $100\mu$ m~$1000\mu$ m to realize the time constant more than $100\mu$ S.

Thus, the size of capacitor C and transistor $T_R$ have not been able to be made small in the prior art actually, there has been a fact that it is hard to realize the long time-interval like 10m S even though cannel length L is $1000\mu$ m and the size of capacitor C is $400\times400$ ($\mu$ m)$^2$.

Moreover, there is another problem of channel length L. When the temperature of the memory chip increases, a leak current which flows in a junction part of a MIST geneally tends to increase. So, the leak current must be compensated by making a compensating current flow through the channel of the MIST. However the compensating current cannot be made flow when channel length L is so long as $1000\mu$ m. Therefore, increasing the capacitance of capacitor C is only a remained means to obtain the long time-interval. The increase of the capacitance makes the size of capacitor C, therefore the size of the memory chip, increase more. Thus, the charge-up circuit of the prior art has the problems as to the cost and the size. The high reliability also cannot be expected from the charge-up circuit of the prior art.

Summary of the invention

An object of the present invention is to provide a charge-up circuit having a relatively slow charge-up characteristic for its size, which is particularly useful for, for example, an erasing-writing voltage generator or a timer circuit having a long time-interval to change the data of an EEPROM or an NOVRAM fabricated in the memory chip.

The other object of the present invention is to provide a charge-up circuit capable of charging up a capacitor up to a realtively high voltage without use of a special depletion type MIST.

Another object of the present invention is to enable application of a charge-up capacitor which has an ordinary little capacitance to the charge-up circuit having a slow charge-up characteristic.

Still another object of the present invention is to decrease the size of the area required by the charge-up circuit.

Yet another object of the present invention is to decrease the fabrication cost of the charge-up circuit.

Further object of the present invention is to increase the accuracy of a long time-interval produced from the charge-up circuit.

Still further object of the present invention is to improve the fabrication reliability of the charge-up circuit.

The charge-up circuit of the present invention is basically comprised of a charge-up capacitor, a first MIS transistor (MIST 1) for charging up the charge-up capacitor, a charge-pump circuit and a voltage suppressing means which, in cooperating with the charge-pump circuit, controls the gate voltage of the MIS transistor. The charge-pump circuit is driven by series of clock pulses and generates a higher voltage on the basis of the voltage at a charge-up node to which the charge-up capacitor is connected. Thus obtained higher voltage is applied to the gate of the MIST 1 to which, however, the voltage suppressing means is connected, so that the gate voltage is controlled and a small charge-up current flows through the MIST 1 to the charge-up capacitor. As the charge-up operation proceeds, the voltage at the gate of the MIST 1 is raised along with the increase of charge-up voltage by the charge-pump circuit with the series of clock pulses applied thereto.

The voltage suppressing means may be preferably comprised of a second MIS transistor (MIST 2) having a gate and a drain both connected to the gate of the MIST 1, and a source connected to the charge-up node. Both transistors MIST 1 and MIST 2 can be advantageously produced in an IC chip so as to have substantially the same threshold voltage characteristic. This facilitates the circuit design because the gate voltage of MIST 1 can be clamped at a level of its source potential plus the gate threshold voltage by the MIST 2, which is most desirable to make the charge-up current as low as possible. In this configuration, the MIST 2 suppresses the voltage applied to the gate of the MIST 1 from the charge-pump circuit so that the charging current flows only in a short period every time the clock pulse is applied.

As the charge-pump circuit uses the charge-up voltage on the charge-up capacitor as a source voltage, when the clock pulse is applied, the output voltage applied to the gate of the MIST 1 can be always made so as to exceed the threshold voltage of the MIST 1. So, the ordinary enhancement type MIST can be applied to the MIST 1 though the level of the charge-up voltage widely changes from a low level to a high level to obtain the long time-interval. As the charging current which intermittently flows through the MIST 1 is limited to a small amount, the charge-up circuit can generate the erasing-writing voltage having the long time-interval though the capacitance of the charge-up capacitance is small.

Thus, applying the present invention, the charge-up circuit can provide a very long time-interval only using a small capacitor and the ordinary enhancement type MIS transistors. Furthermore, applying the charge-pump circuit to the charge-up circuit, the MIST 1 can control certainly the charging current though the back bias of MIST 1 becomes deep.

Brief description of the drawings

Fig. 1 is a circuit diagram of a charge-up circuit embodying the present invention;

Fig. 2(a) is a waveform of a clock signal $\phi$ applied to the charge-up circuit;

Fig. 2(b) is a waveform at $P_1$ in the charge-up circuit;

Fig. 2(c) is a waveform at $P_2$ in the charge-up circuit;

Fig. 2(d) is a waveform of an output voltage $V_0$ of the charge-up circuit;

Fig. 2(e) is a waveform of a charging current $i_c$ which flows through a MIST $T_{R1}$ of the charge-up circuit;

Fig. 2(f) is a waveform of a source-drain current $i_p$ of a MIST $T_{R2}$ of the charge-up circuit;

Fig 3 is a rising curve of the output voltage $V_0$ of the charge-up circuit;

Fig. 4(a) is a schematic circuit diagram of a charge-up circuit of the prior art;

Fig. 4(b) is a rising curve of a charge up voltage on a capacitor C of the charge-up circuit of the prior art;

Fig. 5(a) is a cut view of a general MIST; and

Fig. 5(b) is the partial threshold voltage along a channel width W of the general MIST.

Detailed description of the preferred embodiment

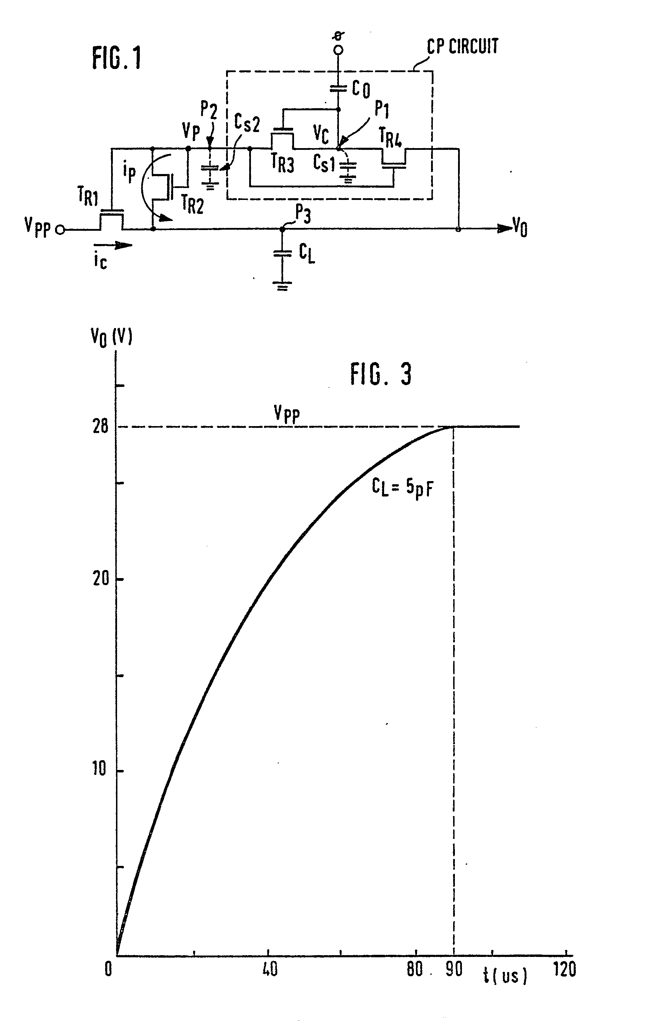

The present invention will become clear from the detailed description of an embodiment with reference to the drawings of Figs. 1~3.

Fig. 1 is a charge-up circuit embodying the present invention fabricated in a memory chip which comprises the EEPROM or the NOVRAM. In the figure, symbols $T_{R1} \sim T_{R4}$ are the E (enhancement) type N channel MIS transistors. The transistor $T_{R1}$ and a charge-up capacitor $C_L$ construct the CR circuit having a long time constant. A chargeing current $i_c$ flows to charge-up capacitor $C_L$ form a high voltage source $V_{PP}$ ($V_{PP}$ will also be used as a high voltage source hereinafter) through transistor $T_{R1}$, and a charge-up voltage $V_0$ on a charge-up node $P_3$, to which the charge-up capacitor $C_L$ is connected, is an output voltage of the charge-up circuit which is the E—W voltage. A coupling capacitor $C_0$, transistor $T_{R3}$, and transistor $T_{R4}$ construct a charge-pump (CP) circuit as shown by a dotted four-sided enclosure in Fig. 1. The CP circuit is connected between charge-up node $P_3$ and the gate of transistor $T_{R1}$ (node $P_2$), and transistors $T_{R3}$ and $T_{R4}$ are connected in series at node $P_1$ to which capacitor $C_0$ is also connected. The transistor $T_{R2}$ is connected between node $P_2$ and charge-up node $P_3$, and its drain and gate are connected to node $P_2$.

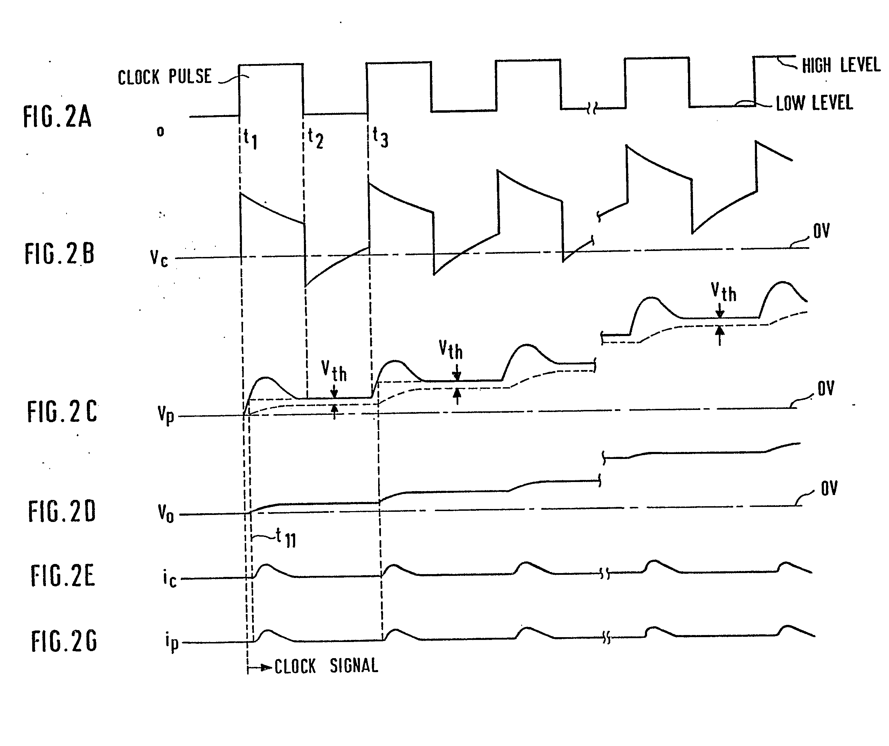

The CP circuit uses charge-up voltage $V_0$ as its source voltage, and an output voltage $V_p$ of the CP circuit is applied to node $P_2$. The function of the CP circuit will be discussed with reference to Fig. 2 which shows the waveforms and a timing diagram of the voltage at respective nodes $P_1$, $P_2$, and $P_3$, the charging current $i_c$ which flows through transistor $T_{R1}$, and a drain — source current $i_p$ of transistor $T_{R2}$. The CP circuit initially does not operate until a clock signal $\phi$ is applied

to the CP circuit (to the coupling capacitor $C_0$). Not only the CP circuit but also the charge-up circuit does not operate as long as the data of EEPROM are not intended to be changed, and when the memory chip receives a command from the computer system to change the data, the CP circuit starts to operate receiving the clock signal. The clock signal may be applied from a clock oscillator of the prior art fabricated in the memory chip for internally generating the high source voltage. In the initial condition, voltage $V_P$ at node $P_2$ is low (0 V for example) so that transistors $T_{R3}$ and $T_{R4}$ are cut off. When the clock signal is applied to the CP circuit at time $t_1$ as shown in Fig. 2(a), voltage $V_c$ at node $P_1$ simultaneously rises up to a voltage (+4.8 V for example, when the amplitude of the clock pusle is 5V) as shown in Fig. 2(b). The amount of voltage $V_c$ rapidly raised is determined by the ratio of $C_0$ to a stray capacitor $C_{s1}$ which exists at node $P_1$ because of the gate capacitance of transistor $T_{R3}$ for example. As a result, transistors $T_{R3}$ and $T_{R4}$ become ON and OFF respectively, which causes transistor $T_{R3}$ to conduct the charge on stray capacitor $C_{s1}$ to a stray capacitor $C_{s2}$ which exists at node $P_2$ because of the gate capacitance of transistors $T_{R1}$ and $T_{R2}$ for example. Then, voltage $V_P$ starts to increase at time $t_1$ as shown in Fig. 2(c) and at the same time voltage $V_c$ starts to decrease as shown in Fig. 2(b); the increase of voltage $V_p$ and the decrease of voltage $V_c$ are made not so rapidly because of the source-drain reistance of transistor $T_{R3}$. When voltgage $V_P$ increases and exceeds a threshold voltage $V_{th}$ of transistor $T_{R1}$, transistor $T_{R1}$ becomes ON and starts to make the charging current $i_c$ flow into charge-up capacitor $C_L$ from high voltage source $V_{pp}$ at time $t_{11}$. Then, charge-up voltage $V_o$ tends to rise up. However, at the same time, voltage $V_P$ is suppressed by transistor $T_{R2}$. That is, when voltage $V_P$ rises and exceeds the threshold voltage $V_{th}$ of transistor $T_{R2}$, a drain-source current $i_p$ flows lowering voltage $V_p$ as hown in Fig. 2(g). As current $i_p$ flows to charge-up capacitor $C_L$, voltage $V_p$ decreases so as to cut off transistors $T_{R1}$ and $T_{R2}$. This causes charging current $i_c$ of transistor $T_{R1}$ to limit so as to flow in a short period every time the clock pulse is applied. Therefore, finally, charging current $i_c$ and charge-up voltage $V_o$ become as shown in Figs. 2(e) and (d) respectively.

When the level of the clock signal rapidly drops at time $t_2$ as shown in Fig. 2(a), voltage $V_c$ also rapidly falls as shown in Fig. 2(b), so that transistors $T_{R3}$ and $T_{R4}$ become OFF and ON respectively. The rapid drop of voltage $V_c$ means rapid negative charge on stray capacitor $C_{s1}$, and the negative charge is gradually discharged by a discharging current which flows through transistor $T_{R4}$ from charge-up voltage $V_o$. Then, voltage $V_c$ drops as low as below 0 V at initial time, and the mean voltage of voltage $V_c$ gradually increases every time the clock pulses are applied successively as shown in Fig. 2(b). Because the discharging current which flows through transistor $T_{R4}$ is supplied from charge-up voltage $V_o$

which gradually increases every time the clock pulse is applied. On the other hand, when voltage $V_c$ rapidly drops, transistor $T_{R3}$ is rapidly cut off, so the rapid drop of voltage $V_c$ gives almost no influence to voltage $V_p$, so that voltage $V_p$ holds the same amount to that of before, in other words, transistors $T_{R1}$ and $T_{R2}$ are kept being cut off by voltage $V_p$ (the rapid drop of voltage $V_c$ is transferred to node $P_2$ through the gate capacitance of transistor $T_{R3}$, however the gate capacitance is too small comparing with stray capacitor $C_{s2}$, so actually no influence of the drop appears on voltage $V_p$). Therefore, the state that transistors $T_{R1}$ and $T_{R2}$ are cut off is kept until next clock pulse is applied.

When clock signal again rises up to the high level at time $t_3$, the charge-up circuit operates similarly to the above. Thus, the operation of the charge-up circuit is repeated every time the clock pulse is applied to the charge-up circuit untill the clock signal is over. That is, as long as the clock signal is applied to the charge-up circuit, charge-up voltage $V_o$ rises up step by step with a little amount as shown in Fig. 2(d) until charge-up voltage $V_o$ reaches the level of high source voltage $V_{pp}$. Therefore, the long time-interval can be obtained, even through the capacitance of charge-up capacitor $C_L$ is small.

In case where this charge-up circuit is to be used in a timer circuit, the end point of the charge-up operation is determined by detecting a predetermined voltage level at node $P_3$ by a voltage detecting circuit as in the prior art device. When this end point voltage is detected, the levels of charge-up voltage $V_o$ and voltage $V_p$ fall down to a initial level of almost 0 V by means of a reset circuit (not shown in a figure).

The transistors $T_{R1}$ and $T_{R2}$ can be always turned on every time the clock signal rises up to its high level, because $V_p$ has been always kept to be just below the voltage $V_o+V_{th}$ when the clock signal is in its low level. Therefore, a special D type MIST like what requires the ion implantation mask for the fabrication is not necessary anymore for transistors $T_{R1}$ and $T_{R2}$, the ordinary E type MIST is enough for them. The ordinary E type transistors can be also applied to transistors $T_{R3}$ and $T_{R4}$ used in the CP circuit.

Fig. 3 shows a result of a simulation example about the invented charge-up circuit. The result is obtained by the following condition: $V_{PP}$ is 28 V; charge-up capacitor $C_L$ is 5 PF; the frequency and the amplitude of the clock signal are 8 MH$_z$ (mega-Hertz) and 5'V respectively; the ratio of the channel W/L (width to length) of respective transistors are 4($\mu$ m)/4($\mu$ m) for transistors $T_{R1}$, $T_{R3}$, and $T_{R4}$, and 4($\mu$ m/16($\mu$m) for transistor $T_{R2}$; and the ratio of width to length of coupling capacitor $C_0$ is 20($\mu$ m). Under the above condition, the ordinary E type transistor can be applied for all transistors used in the charge-up circuit. The value of 5p F of charge-up capacitor $C_L$ is a standard capacitance, so MIST having the channel dimension of

$$100(\mu\,m)W \times 100(\mu\,m)L$$

with the capacitor dielectric ($S_iO_2$) thickness of 600 angstrom can be used. Fig. 3 shows that a charge-up time of $90\mu\,S$ can be obtained using the high source voltage $V_{pp}$ of 28V even though charge-up capacitor $C_L$ is only 5 pF. Of course, the charge-up time can be controlled by varying the characteristics of transistors $T_{R1}$ and $T_{R2}$ and/or the capacitance of coupling capacitor $C_0$.

## Claims

1. A charge-up circuit, operative under application of a source voltage ($V_{pp}$) and a series of clock pulses ($\phi$), for gradually charging up a charge-up node ($P_3$), characterized in:

a charge-up capacitor ($C_L$) connected to said charge-up node ($P_3$);

a first MIS transistor ($T_{R1}$) having a gate, source and drain, one of said source and drain being operatively connected to said charge-up node ($P_3$), the other of said source and drain being operatively connected to receive said source voltage ($V_{pp}$);

a charge-pump circuit (CP) operatively connected between said charge-up node ($P_3$) and said gate of said first MIS transistor ($T_{R1}$) and operatively connected to receive said clock pulses ($\phi$), for generating a voltage ($V_p$) higher than that at said charge-up node ($P_3$) in response to said clock pulses ($\phi$) and applying said voltage ($V_p$) to said gate of said first MIS transistor ($T_{R1}$); and

voltage suppressing means ($T_{R2}$) operatively connected between said gate of said first transistor ($T_{R1}$) and said charge-up node ($P_3$) for suppressing the voltage between said gate of said first MIS transistor ($T_{R1}$) and said charge-up node (P3), said first MIS transistor ($T_{R1}$) conducting a charge-up current ($i_c$) from the source voltage ($V_{pp}$) to said charge-up node ($P_3$) under the control of the voltage ($V_p$) at said gate determined by cooperation of said charge-pump circuit (CP) and said voltage suppressing means ($T_{R2}$).

2. A charge-up circuit according to claim 1, characterized in that said first MIS transistor ($T_{R1}$) is of enhancement type.

3. A charge-up circuit according to claim 1 or 2, characterized in that said voltage suppressing means comprises a second MIS transistor ($T_{R2}$) havig a gate, source and drain, said gate and drain of said second MIS transistor ($T_{R2}$) being connected to said gate of said first MIS transistor ($T_{R1}$), said source of said second MIS transistor ($T_{R2}$) being connected to said charge-up node ($P_3$).

4. A charge-up circuit according to any one of claims 1 to 3, characterized in that said first and second MIS transistors ($T_{R1}$, $T_{R2}$) are of enhancement type.

5. A charge-up circuit according to any one of claims 1 to 4, characterized in that said charge-pump circuit (CP) comprises:

a capacitor ($C_0$) having first and second terminals, said first terminal being operatively connected to receive said clock pulses ($\phi$);

a first means ($T_{R3}$), connected between said second terminal of said capacitor ($C_0$) and said gate of said first MIS transistor ($T_{R1}$), for allowing a current to flow from said second terminal of said capacitor ($C_0$) to said gate of said first MIS transistor ($T_{R1}$) during a period in which one of said clock pulses ($\phi$) is applied; and

a second means ($T_{R4}$), connected between said charge-up node ($P_3$) and said second terminal of said capacitor ($C_0$), for allowing a current to flow from said charge-up node ($P_3$) to said second terminal of said capacitor ($C_0$) after said period.

6. A charge-up circuit according to claim 5, characterized in that said first means comprises a third MIS transistor ($T_{R3}$) having a gate connected to said second terminal of said capacitor ($C_0$), a source and a drain, one of said source and drain being connected to said second terminal of said capacitor ($C_0$), the other of said source and drain being connected to said gate of said first MIS transistor ($T_{R1}$).

7. A charge-up circuit according to claim 5 or 6, characterized in that said second means comprises a fourth MIS transistor ($T_{R4}$) having a gate connected to said gate of said first MIS transistor ($T_{R1}$), a source and a drain, one of said source and drain of said fourth MIS transistor ($T_{R4}$) being connected to said second terminal of said capacitor ($C_0$), the other of said source and drain of said fourth MIS transistor ($T_{R4}$) being connected to said charge-up node ($P_3$).

## Patentansprüche

1. Afladeschaltung, die beim Anlegen einer Versorgungsspannung ($V_{pp}$) und einer Reihe von Taktimpulsen ($\phi$) einen Aufladeknotenpunkt ($P_3$) schrittweise auflädt,
gekennzeichnet durch
einen mit dem Aufladeknotenpunkt ($P_3$) verbundenen Ladekondensator ($C_L$),
ersten MIS-Transistor ($T_{R1}$) mit einem Gate, einer Source- und einer Drain-Elektrode, wobei von der Source- und der Drain-Elektrode eine wirkungsmäßig mit dem Aufladeknotenpunkt ($P_3$) verbunden ist und die andere die Versorgungsspannung ($V_{pp}$) aufnimmt,
eine zwischen dem Aufladeknotenpunkt ($P_3$) und dem Gate des ersten MIS-Transistors ($T_{R1}$) angeordnete, mit den Taktimpulsen ($\phi$) beaufschlagbare Ladungs-Pumpschaltung (CP) zur Erzeugung einer Spannung ($V_p$) in Abhängigkeit von den Taktimpulsen ($\phi$), die größer ist als die Spannung an dem Aufladeknotenpunkt ($P_3$), und zum Anlegen dieser Spannung ($V_p$) an das Gate des ersten MIS-Transistors ($T_{R1}$), und
eine zwischen dem Gate des ersten MIS-Transistors ($T_{R1}$) und dem Aufladeknotenpunkt ($P_3$) angeordnete Einrichtung ($T_{R2}$) zu Unterdrückung der Spannnung zwischen dem Gate des ersten MIS-Transistors ($T_{R1}$) und dem Aufladeknotenpunkt ($P_3$), wobei der MIS-Transistor ($T_{R1}$) unter dem Steuereinfluß der Spannung ($V_p$) an dem Gate, die durch das Zusammenwirken der Ladungs-Pumpschaltung (CP) und der Einrichtung ($T_{R2}$) zur Spannungsunterdrückung bestimmt ist, einem Aufladestrom ($i_c$) von der Versorgungsspannung ($V_{pp}$) zun dem Aufladeknotenpunkt ($P_3$) führt.

2. Aufladeschaltung nach Anspruch 1, dadurch gekennzeichnet, daß der erste MIS-Transistor ($T_{R1}$) ein Transistor vom Anreicherungstyp ist.

3. Aufladeschaltung nach Anspruch 1 oder 2, dadurch gekennzeicnhet, daß die Einrichtung ($T_{R2}$) zur Spannungsunterdrückung einen zweiten MIS-Transistor ($T_{R2}$) mit einem Gate, einer Source- und einer Drain-Elektrode enthält, wobei das Gate und die Drain-Elektrode des zweiten MIS-Transistors ($T_{R2}$) mit dem Gate des ersten MIS-Transistors ($T_{R1}$) und die Source-Elektrode des zweiten MIS-Transistors ($T_{R2}$) mit dem Aufladeknotenpunkt ($P_3$) verbunden sind.

4. Aufladeschaltung nach einem der Ansprüche 1 bis 3, dadurch gekennzeichnet, daß der erste und der zweite MIS-Transistor ($T_{R1}$, $T_{R2}$) vom Anreicherungstyp sind.

5. Aufladeschaltung nach einem der Ansprüche 1 bis 4, dadurch gekennzeichnet, daß die Ladungs-Pumpschaltung (CP) folgende Teil aufweist:
einen Kondensator ($C_0$) mit einem ersten und einem zweiten Anschluß, wobei der erste Anschluß die Taktimpulse ($\phi$) aufnimmt,
ein zwischen dem zweiten Anschluß des Kondensators ($C_0$) und dem Gate des ersten MIS-Transistors ($T_{R1}$) angeordnetes erstes Schaltmittel ($T_{R3}$), das während einer Periode, in der einer der Taktimpulse ($\phi$) anliegt, einen Stromfluß von dem zweiten Anschluß des Kondensators ($C_0$) zu dem Gate des ersten MIS-Transistors ($T_{R1}$) ermöglicht,
und ein zwischen dem Aufladeknotenpunkt ($P_3$) und dem zweiten Anschluß des Kondensators ($C_0$) angeordnete zweites Schaltmittel ($T_{R4}$), das nach der genannten Periode einen Stromfluß von dem Aufladeknotenpunkt ($P_3$) zum zweiten Anschluß des Kondensators ($C_0$) ermöglicht,

6. Aufladeschaltung nach Anspruch 5, dadurch gekennzeichnet, daß das erste Schaltmittel einen dritten MIS-Transistor ($T_{R3}$) aufweist, der ein mit dem zweiten Anschluß des Kondensators ($C_0$) verbundenes Gate, eine Source- und eine Drain-Elektrode besitzt, wobei von der Source- und der Drain-Elektrode eine mit dem zweiten Anschluß des Kondensators ($C_0$) und die andere mit dem Gate des ersten MIS-Transistors ($T_{R1}$) verbunden ist.

7. Aufladeschaltung nach Anspruch 5 oder 6, dadurch gekennzeichnet, daß das zweite Schaltmittel einen vierten MIS-Transistor ($T_{R4}$) aufweist, der ein mit dem Gate des ersten MIS-Transistors ($T_{R1}$) verbundenes Gate, eine Source- und eine Drain-Elektrode besitzt, wobei von der Source- und der Drain-Elektroden eine mit dem zweiten Anschluß des Kondensators ($C_0$) und die andere mit Aufladeknotenpunkt ($P_3$) verbunden ist.

**Revendications**

1. Circuit de charge, fonctionant sous l'effet de l'application d'un tension de source ($V_{pp}$) ainsi que d'une série d'impulsions d'horloge ($\phi$), permettant de charger graduellement un noeud de charge ($P_3$), caractérisé en ce qu'il comprend:
— une capacité de charge ($C_L$) reliée au noeud de charge ($P_3$);
— un premier transistor MIS ($T_{R1}$) comportant une grille, une source et un drain, l'une des zones de source ou de drain étant reliée de manière opérationnelle au noeud de charge ($P_3$), l'autre zone de source ou de drain étant reliée de manière opérationnelle pour recevoir la tension de source ($V_{pp}$);
— un circuit de pompage de charge (CP) relié de manière opérationnelle entre le noeud de charge ($P_3$) et la grille du premier transistor MIS ($T_{R1}$) et étant relié de manière opérationnelle pour recevoir les impulsions d'horloge ($\phi$), afin de générer une tension ($V_p$) supérieure à la tension présente au niveau du noeud de charge ($P_3$) en réponse aux impulsions d'horloge ($\phi$) et afin d'appliquer la tension ($V_p$) à la grille du premier transistor MIS ($T_{R1}$); et
— un moyen de suppression de tension ($T_{R2}$) relié de manière opérationnelle entre la grille du premier transistor ($T_{R1}$) et le noeud de charge ($P_3$) pour supprimer la tension entre la grille du premier transistor MIS ($T_{R1}$) et le noeud de charge ($P_3$), le premier transistor MIS ($T_{R1}$) conduisant un courant de charge ($i_c$) depuis la tension de source ($V_{pp}$) jusqu'au noeud de charge ($P_3$) sous la commande de la tension ($V_p$) présente au niveau de la grille, cette tension étant déterminée par l'action conjuguée du circuit de pompage de charge (CP) et du moyen de suppression de tension ($T_{R2}$).

2. Circuit de charge selon la revendication 1, caractérisé en ce que le premier transistor MIS ($T_{R1}$) est du type à enrichissement.

3. Circuit de charge selon la revendication 1 ou la revendication 2, caractérisé en ce que le moyen de suppression de tension comprend un second transistor MIS ($T_{R2}$) qui comporte une grille, une source et un drain, la grille et le drain du second transistor MIS ($T_{R2}$) étant reliés à la grille du premier transistor MIS ($T_{R1}$), la source du second transistor MIS ($T_{R2}$) étant reliée au noeud de charge ($P_3$).

4. Circuit de charge selon l'une quelconque des revendications 1 à 3, caractérisé en ce que les premier et second transistors MIS ($T_{R1}$, $T_{R2}$) sont du type à enrichissement.

5. Circuit de charge selon l'une quelconque des revendications 1 à 4, caractérisé en ce que le circuit de pompage de charge (CP) comprend:
— une capacité ($C_0$) comportant des première et seconde bornes, la première borne étant reliée de manière opérationnelle pour recevoir les impulsions d'horloge ($\phi$);
— un premier moyen ($T_{R3}$), relié entre la seconde borne de la capacité ($C_0$) et la grille du premier transistor MIS ($T_{R1}$), pour permettre à un courant de circular depuis la seconde borne de la capacité ($C_0$) jusqu'à la grille du premier transistor MIS ($T_{R1}$), et ce durant une période au cours de laquelle une des impulsions d'horloge ($\phi$) est appliquée; et

— un second moyen ($T_{R4}$), relié entre le noeud de charge ($P_3$) et la seconde borne de la capacité ($C_0$), pour permettre à un courant de circuler depuis le noeud de charge ($P_3$) jusqu'à la seconde borne de la capacité ($C_0$) après la période précitée.

6. Circuit de charge selon la revendication 5, caractérisé en ce que le premier moyen comprend un troisième transistor MIS ($T_{R3}$) qui comporte une grille reliée à la seconde borne de la capacité ($C_0$), une source et un drain, l'une des zones de source ou de drain étant reliée à la seconde borne de la capacité ($C_0$), l'autre zone de source ou de drain étant reliée à la grille du premier transistor MIS ($T_{R1}$).

7. Circuit de charge selon la revendication 5 ou la revendication 6, caractérisé en ce que le second moyen comprend un quatrième transistor MIS ($T_{R4}$) qui comporte une grille reliée à la grille du premier transistor MIS ($T_{R1}$), une source et un drain, l'une des zones de source ou de drain du quatrième transistor MIS ($T_{R4}$) étant reliée à la seconde borne de la capacité ($C_0$), l'autre zone de source ou de drain du quatrième transistor MIS ($T_{R4}$) étant reliée au noeud de charge ($P_3$).

FIG. 1

CP CIRCUIT

FIG. 3

CLOCK PULSE

HIGH LEVEL

LOW LEVEL

FIG.2A

$t_1$  $t_2$  $t_3$

FIG.2B

$V_c$

0V

$V_{th}$

$V_{th}$

$V_{th}$

FIG.2C

$V_p$

0V

FIG.2D

$V_0$

0V

$t_{11}$

FIG.2E

$i_c$

FIG.2G

$i_p$

CLOCK SIGNAL

PRIOR ART

## FIG. 4 A

## FIG. 4 B

## FIG. 5A

## FIG. 5 B